# EUROPEAN PATENT SPECIFICATION

(11) **EP 3 457 484 B1**
(45) Date of publication and mention of the grant of the patent: **10.06.2020**
(21) Application number: 18194939.7
(22) Date of filing: 17.09.2018
(51) Int. Cl.: H01M 10/052, H01M 10/058, H01M 10/42, H01M 10/48, H01M 2/02

(54) **IN-OPERATION LITHIATION ACCORDING TO SOH MONITORING**
LITHIIERUNG WÄHREND DES BETRIEBS NACH SOH-ÜBERWACHUNG
LITHIATION EN SERVICE SELON LA SURVEILLANCE SOH

(30) Priority: 18.09.2017 US 201715706835
(43) Date of publication of application: 20.03.2019
(73) Proprietor: StoreDot Ltd., 4673300 Herzeliya (IL)
(72) Inventor: PAZ, Ron, 7656323 Rehovot (IL); KEDEM, Nir, 3457421 Haifa (IL); BURSHTAIN, Doron, 4648807 Herzliya (IL); BARAM, Nir, 7402766 Ness-Ziona (IL); POUR, Nir, 1527600 Lower Galilee (IL); ARONOV, Daniel, 4266107 Netanya (IL)
(74) Representative: Pearl Cohen Zedek Latzer Baratz UK LLP

(56) References cited:
- WO-A1-2011/083423
- WO-A2-2009/036444
- DE-A1-102015 211 935

## Description

### BACKGROUND OF THE INVENTION

### TECHNICAL FIELD

The present invention relates to the field of lithium ion batteries, and more particularly, to metal ion regulation processes.

### DISCUSSION OF RELATED ART

Continuous effort is made to develop lithium ion batteries with longer cycling lifetime, enhanced safety and higher charging rates.

DE102015211935 describes a method for controlling a regeneration procedure of a lithium battery cell which comprises an anode, a cathode and the regeneration electrode. The method comprises: detecting a current availability of cyclable lithium in the anode; detecting a current availability of cyclable lithium in the cathode; passing a first current between the anode and the regeneration electrode until the actual availability of cyclable lithium in the anode corresponds to a targeted availability of cyclable lithium in the anode; and passing a second current between the cathode and the regeneration electrode until the current availability of cyclable lithium in the cathode corresponds to a targeted availability of cyclable lithium in the cathode.

WO2011/083423 describes lithium-ion secondary electrochemical cells and methods of making lithium-ion secondary electrochemical cells.

WO2009/036444 discloses a battery management system which includes one or more lithium ion cells in electrical connection, each said cell comprising: first and second working electrodes and one or more reference electrodes, each reference electrode electronically isolated from the working electrodes and having a separate tab or current collector exiting the cell and providing an additional terminal for electrical measurement; and a battery management system comprising a battery state-of-charge monitor, said monitor being operable for receiving information relating to the potential difference of the working electrodes and the potential of one or more of the working electrodes versus the reference electrode.

### SUMMARY OF THE INVENTION

One aspect of the present invention provides a method comprising lithiating electrodes of a lithium ion battery during its operation, carried out electrochemically between the electrodes and a lithium source which is embedded in the battery, and controllably with respect to a state of health (SoH) of the lithium ion battery. The method is defined in claim 1.

A further aspect of the present invention concerns a system according to claim 9.

These, additional, and/or other aspects and/or advantages of the present invention are set forth in the detailed description which follows; possibly inferable from the detailed description; and/or learnable by practice of the present invention.

### BRIEF DESCRIPTION OF THE DRAWINGS

For a better understanding of embodiments of the invention and to show how the same may be carried into effect, reference will now be made, purely by way of example, to the accompanying drawings in which like numerals designate corresponding elements or sections throughout.

In the accompanying drawings:
**Figure 1** is a high level schematic illustration of metal ion regulation processes in cells for lithium ion batteries, according to some embodiments of the invention.
**Figure 2** is a high level schematic illustration of lithium consumption processes in prior art cells for lithium ion batteries.
**Figures 3A-3C** are high level schematic illustrations of cell stacks for lithium ion batteries, comprising alternating anodes, separators and cathodes packaged in a pouch cover, according to some embodiments of the invention.
**Figures 4A-4C** are high level schematic illustrations of systems and battery configurations having various lithium metal sources, according to some embodiments of the invention
**Figures 5A** and **5B** are high level schematic illustrations of systems and battery configurations having a removable lithium metal source, according to some embodiments of the invention.
**Figures 5C** and **5D** are high level schematic illustrations of system and battery configurations for lithiation during operation, according to some embodiments of the invention.
**Figure 6** is a high level schematic illustration of battery configurations having lithium metal sources as beads adjacent to anode(s), according to some embodiments of the invention.
**Figures 7A** and **7B** are high level schematic illustrations of battery configurations having lithium metal sources which are incorporated in current collector(s), according to some embodiments of the invention
**Figures 8-10** are high level schematic illustrations of system configurations with fluid flow regulation of metal ion levels in one or more electrode, according to some embodiments of the invention.
**Figure 11** is a high level flowchart illustrating a method, according to some embodiments of the invention.
**Figure 12** provides an example of results illustrating the improved operation of batteries resulting from systems and/or methods, according to some embodiments of the invention.

### DETAILED DESCRIPTION OF THE INVENTION

In the following description, various aspects of the present invention are described. For purposes of explanation, specific configurations and details are set forth in order to provide a thorough understanding of the present invention. However, it will also be apparent to one skilled in the art that the present invention may be practiced without the specific details presented herein. Furthermore, well known features may have been omitted or simplified in order not to obscure the present invention. With specific reference to the drawings, it is stressed that the particulars shown are by way of example and for purposes of illustrative discussion of the present invention only and are presented in the cause of providing what is believed to be the most useful and readily understood description of the principles and conceptual aspects of the invention. In this regard, no attempt is made to show structural details of the invention in more detail than is necessary for a fundamental understanding of the invention, the description taken with the drawings making apparent to those skilled in the art how the several forms of the invention may be embodied in practice.

Before at least one embodiment of the invention is explained in detail, it is to be understood that the invention is not limited in its application to the details of construction and the arrangement of the components set forth in the following description or illustrated in the drawings. The invention is applicable to other embodiments that may be practiced or carried out in various ways as well as to combinations of the disclosed embodiments. Also, it is to be understood that the phraseology and terminology employed herein are for the purpose of description and should not be regarded as limiting.

Unless specifically stated otherwise, as apparent from the following discussions, it is appreciated that throughout the specification discussions utilizing terms such as "processing", "computing", "calculating", "determining", "enhancing", "deriving", "distinguishing", "monitoring" or the like, may refer to the action and/or processes of a computer or computing system, or similar electronic computing device, that manipulates and/or transforms data represented as physical, such as electronic, quantities within the computing system's registers and/or memories into other data similarly represented as physical quantities within the computing system's memories, registers or other such information storage, transmission or display devices. Any of the disclosed modules or units may be at least partially implemented by a computer processor.

Embodiments of the present invention provide efficient and economical methods and mechanism for lithiating electrodes (e.g., anodes and/or cathodes) of lithium ion cells, and thereby provide improvements to the technological field of lithium ion batteries. In particular, pre-lithiation, which does not belong to the present invention, may provide lithium in advance, to compensate for lithium that is removed from the cathode during formation and is fixated in the SEI (solid electrolyte interphase).
Systems and methods are provided, in which the level of metal ions in cells stacks and lithium ion batteries is regulated in situ, with the electrodes of the cell stack(s) in the respective pouches. Regulation of metal ions may be carried out electrochemically by metal ion sources in the pouches, electrically connected to the electrodes. The position and shape of the metal ion sources may be optimized to create uniform metal ion movements to the electrode surfaces and favorable SEI formation. The metal ion sources may be removable, possibly during the degassing phase after the formation process, or be left in the pouch to provide additional metal ions such as lithium during operation. Regulation of metal ions may be carried out from metal ion sources in separate electrolyte reservoir(s), with circulation of the metal-ion-containing electrolyte through the cell stacks in the pouches prior or during the formation, which does not belong to the present invention. Systems and methods are provided, in which the electrodes of the lithium ion battery are lithiated during the operation of the battery, electrochemically between the respective electrodes and a lithium source which is embedded in the battery, and controllably with respect to the state of health (SoH) of the lithium ion battery.

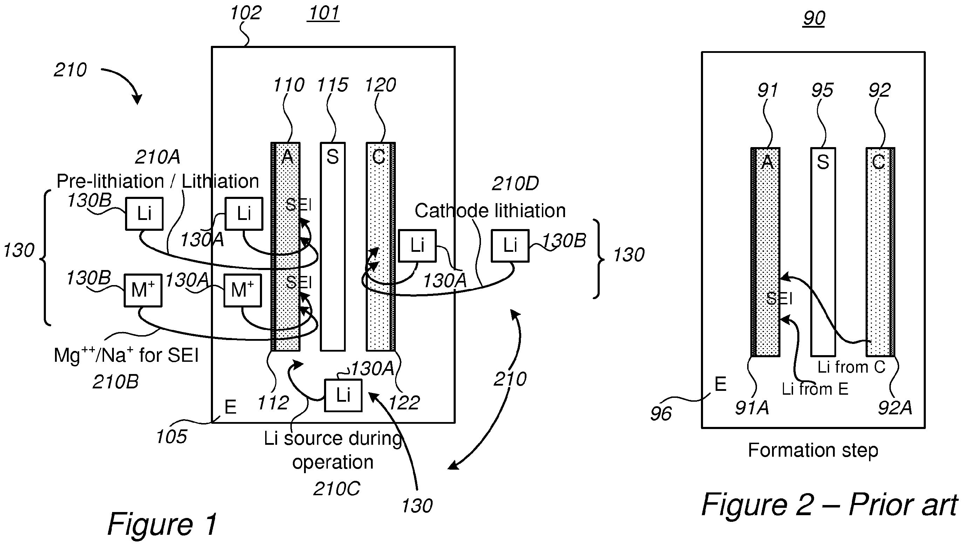

**Figure 1** is a high level schematic illustration of metal ion regulation processes **210** in cells for lithium ion batteries **101,** according to some embodiments of the invention. **Figure 2** is a high level schematic illustration of lithium consumption processes in prior art cells for lithium ion batteries **90.** **Figures 1** and **2** are high level schematic illustrations of cells for lithium ion batteries **101,** comprising anode(s) **110** (with current collector(s) **112**), separator(s) **115** and cathode(s) **120** (with current collector(s) **122**), packaged with an electrolyte **105** in a pouch cover **102,** according to some embodiments of the invention, and of prior art cells for prior art lithium ion batteries **90,** comprising anode(s) **91** (with current collector(s) **91A**), separator(s) **95** and cathode(s) **92** (with current collector(s) **92A**), packaged with an electrolyte **96** in a pouch cover, respectively. **Figures 1** and **2** illustrate a schematic plan view along an axis perpendicular to anodes **110, 91** (denoted "A"), separators **115, 95** (denoted "S") and cathodes **120, 92** (denoted "C"), respectively. It is noted that the figures are very schematic, and merely relate to the ordering of some of the elements of the battery, without reflecting realistic spatial relations, for the sake of clarity of explanation. It is further noted that **Figures 1** and **2** do not illustrate, for simplicity reasons, the fact that electrolytes **105, 96** (denoted "E") contact respective anodes **110, 91** and cathodes **120, 92** in separate compartments, delimited by respective separators **115, 95.**

While in prior art **Figure 2** lithium (Li) is consumed from cathode **92** and/or from electrolyte **96** to form the SEI during the formation step(s) of anode **91** (and possibly during operation as well, to a smaller extent) - the inventors have found that lithium consumption may be mitigated and/or compensated for by any of the following ways, involving regulation of a level of metal ions in at least one electrode (e.g., anode(s) and/or cathode(s)) in the lithium ion battery - illustrated schematically in **Figure 1** as stage **210** with several varieties, and presented in further detail below.

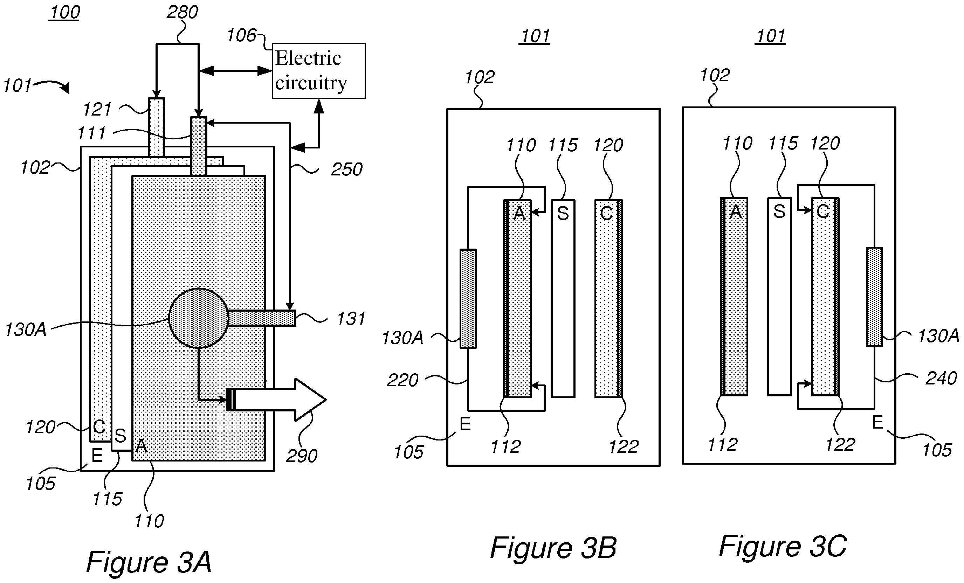

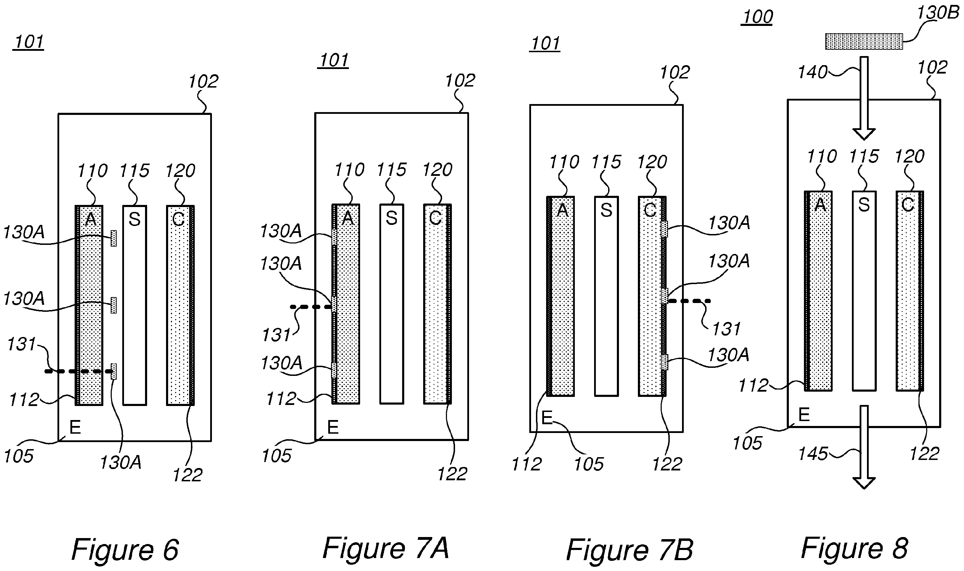

For example, the formation step may be preceded by a pre-lithiation step **210A** of anode(s) **110,** delivering additional lithium from an external source **130B** and/or from an internal source **130A** (with respect to battery pouch **102**), as explained below, e.g., in **Figures 3A-7B** and in **Figures 8-10****,** respectively. Either source **130A, 130B** is referred to below, in corresponding embodiments, as source **130.**

In some embodiments, alternative or complementary, lithiation **210A** of anode(s) **110** may be carried out during the formation step, or possibly even after the formation step and/or during operation, from internal source **130A.**

In some embodiments, alternatively or complementarily, the formation of SEI on anode(s) **110** may be carried out at least partly using a metal ion source **130,** providing **210B** e.g., Li, Mg, Na, Li⁺, Mg⁺⁺, Na⁺ and/or other metal atoms and/or ions to participate in SEI formation, sparing at least some of the lithium consumed in the prior art in the formation process. For example, the inventors note that advantageously, magnesium may be used to form SEI without a risk of dendrite formation, enhancing the battery safety, and moreover having various operational advantages such as cost and safety considerations. Hybrid Mg and Li sources may also be used, possibly with electrolyte salts such as Mg(BH₄)₂ - LiBH₄ and/or APC (all phenyl complex, comprising PhₓMgCl₂₋ₓ and Ph_{y}AlCl_{3-y}) - LiCl in, e.g., THF (tetrahydrofuran). Adaptation of applied voltages **250** (see, e.g., **Figure 3A**) and other operational adaptations relate to Mg redox potential being ca. 0.67V higher than Li. In some embodiments, Na may be used in place of, or in addition to Mg, possibly with electrolyte salts such as NaPF₆ and/or NaClO₄, which are advantageously similar to LiPF₆ and/or LiClO₄ used in typical electrolytes, with the system being adapted according to Na redox potential being ca. 0.33V higher than Li.

Metal ion source **130** may be configured to provide more than one type of metal ions, possibly at a pre-configured quantitative proportions and temporal order. For example, metal ion source **130** may be configured to provide mainly Mg⁺⁺ for SEI formation prior and/or during the formation step, and to provide mainly Li⁺ during and/or after the formation step, possibly to supplant lithium during the operation of batteries **101.**

The internal metal ion source **130A** (e.g., lithium source) is maintained within battery pouch **102** during operation of battery **101** and be configured to provide lithium ions **210C** to compensate for lithium ion consumption during operation as illustrated below, e.g., in **Figures 3C****,** **6, 7A** and **7B****.**

In some embodiments, complementary, external metal ion source **130B** and/or internal lithium source **130A** (e.g., lithium sources) may be used to compensate **210D** for lithium depletion from cathode **120,** by lithiating cathode **120** during the formation process, after the formation process and/or during operation as illustrated below, e.g., in **Figures 3C** and **7B****.**

In the following, any of pre-lithiation **210A,** anode lithiation **210A** during formation, provision **210B** of metal ions to form the SEI, provision **210C** of lithium ions during operation and cathode lithiation **210D** may be carried out by disclosed systems under corresponding operation procedures and are designated commonly as metal ion regulation steps **210.**

**Figures 3A** and **3B** are high level schematic illustrations of cell stacks for lithium ion batteries **101,** comprising alternating anodes **110,** separators **115** and cathodes **120** packaged in pouch cover **102,** according to some embodiments of the invention. **Figure 3A** illustrates a schematic plan view along an axis perpendicular to anodes **110** (denoted "A"), separators **115** (denoted "S") and cathodes **120** (denoted "C") and **Figure 3B** is a side view of anodes **110,** separators **115** and cathodes **120.** It is noted that the figures are very schematic, and merely relate to the ordering of some of the elements of the battery, without reflecting realistic spatial relations, for the sake of clarity of explanation. An electrolyte **105** (denoted "E") contacts anodes **110** and cathodes **120** in separate compartments, delimited by separators **115,** a feature which is not shown in the figures.

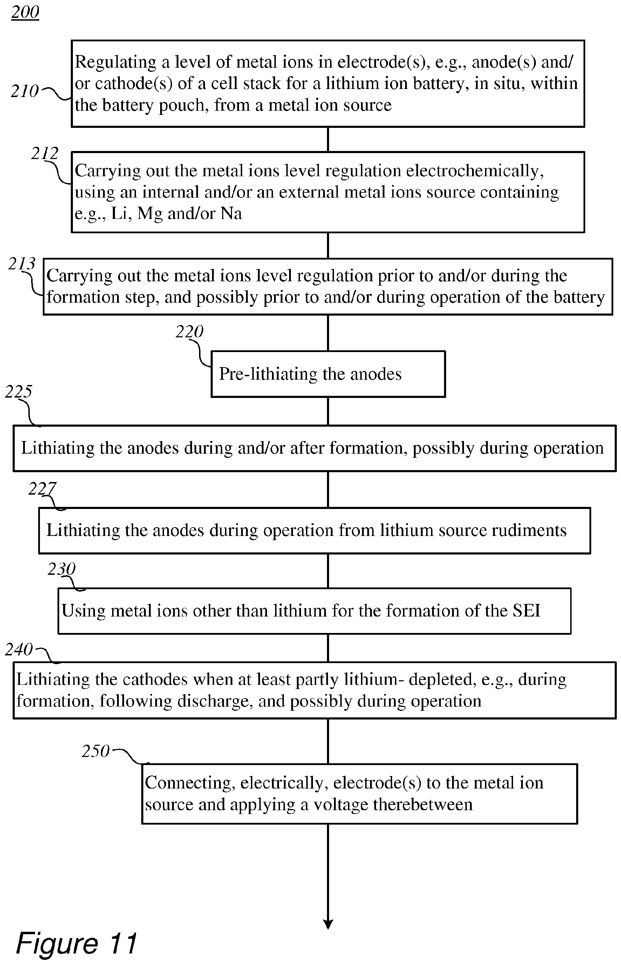

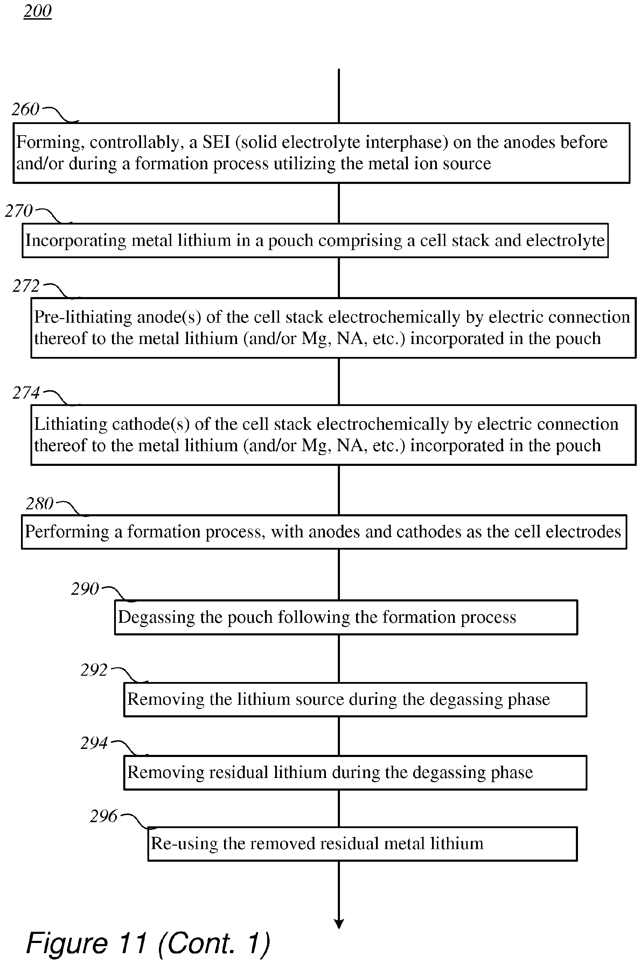

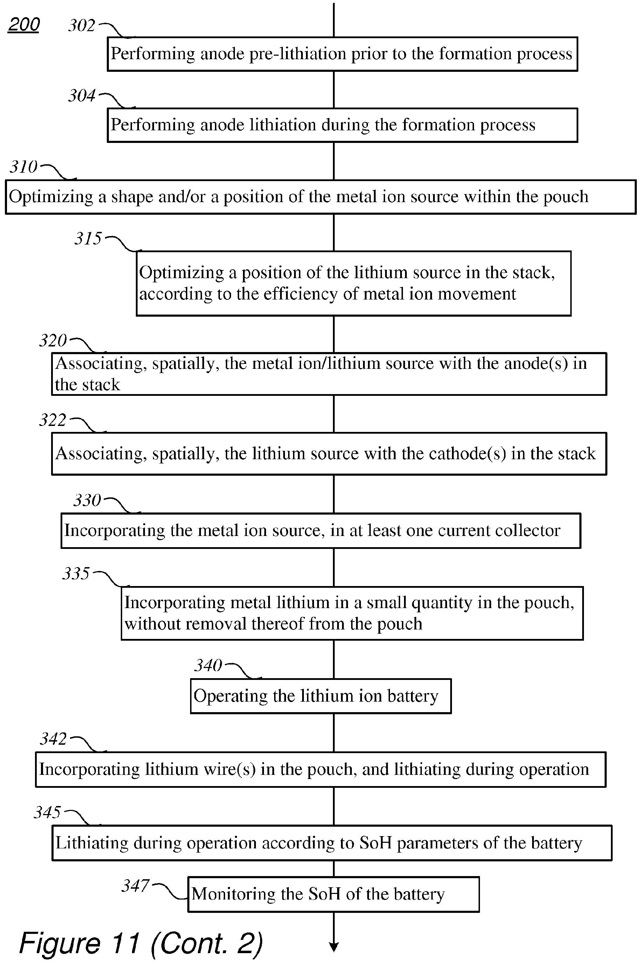

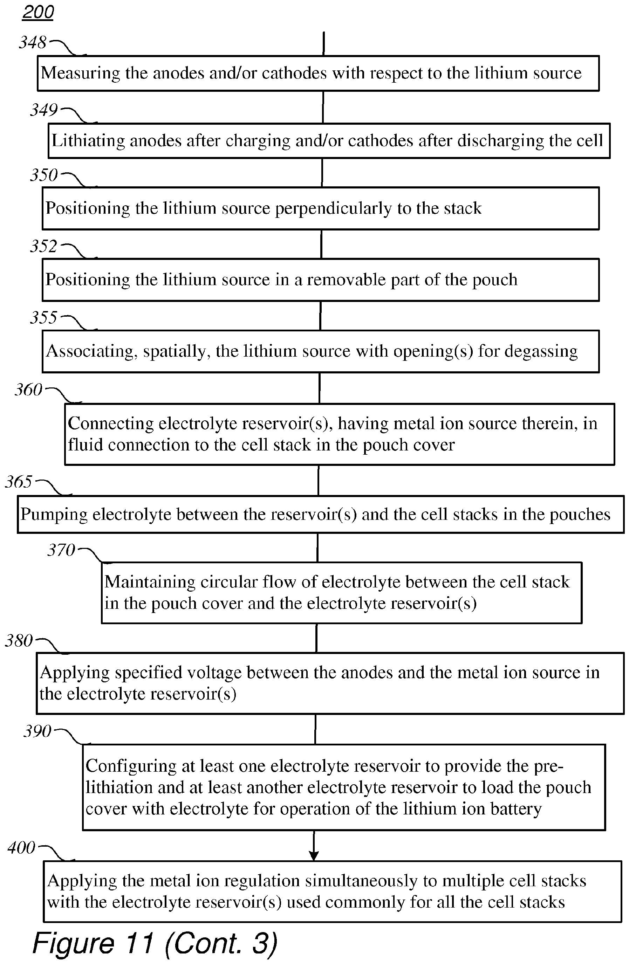

**Figures 3A** and **3B** illustrate systems **100** and batteries **101,** which comprise a lithium metal source **130A** within pouch cover **102,** having an external contact **131** (e.g., one or more external contact(s) **131** such as metallic tabs) electric circuitry **106** (shown schematically), configured to pre-lithiate **210A** (indicated schematically, in relation to SEI formation on anodes **110,** and see **Figure 1**) anodes **110** electrochemically, by applying specified voltage between anodes **110** (e.g., via external contacts **111** thereof, indicated schematically as electric connection and voltage application **250**) and metal ion source **130A** in pouch cover **102** (e.g., via external contacts **131** thereof), prior to a formation process **280** of the lithium ion battery (e.g., via external contacts **111, 121** of anode(s) **110** and cathode(s) **120,** respectively). Formation **280**, which does not belong to the present invention, may be followed by degassing **290** and possibly removal of metal ion source **130.** As illustrated schematically in **Figure 3B****,** prelithiation **210A,** which does not belong to the present invention, results in movement of lithium and/or other metal ions from metal ion source **130** to anode **110,** possibly at least partly forming the SEI (**210A** and/or **210B**) and/or preventing or reducing lithium losses from the cathode **210D** upon formation and/or operation, under corresponding operation conditions (connecting metal ion source, e.g., lithium source **130** to cathode **120** (see **Figure 3C**) and operating electric circuitry **106** during or after formation step **280,** when lithium in cathode(s) **120** is depleted). Arrow **220** indicated schematically the movement of metal ions (e.g., lithium) to anode **110** to form the SEI (see also **Figure 11**).

**Figure 3C** illustrates systems **100** and batteries **101,** which comprise lithium source **130A** within pouch cover **102,** configured to provide additional lithium **210D** to cathodes **120** (indicated schematically, in relation to cathodes **120**), electrochemically, by applying specified voltage between cathodes **120** (e.g., via external contacts **121** thereof) and lithium source **130** (e.g., lithium source) in pouch cover **102** (e.g., via external contacts **131** thereof, see e.g., **Figure 3A**), during and/or after formation process **240** of lithium ion battery **101** (e.g., via external contacts **111, 121** of anode(s) **110** and cathode(s) **120,** respectively). Compensating **210D** for lithium loss at cathode **120** may be carried out independently or complementarily to pre-lithiation and/or lithiation **210A** of anode(s) **110,** SEI formation through metal ions **210B** and/or lithium supply during operation **210C.** Any of anode(s) **110** and cathode(s) **120** may be lithiated in any of the disclosed configurations, sequentially or simultaneously, from same or different metal ion sources **130** (e.g., lithium source, possibly with additional metal sources) and using one or more components of electric circuitry **106.** Arrow **240** indicated schematically the movement of lithium ions to cathode **120** to supplant cathode lithium which is fixated in the SEI or otherwise lost (see also **Figure 11**).

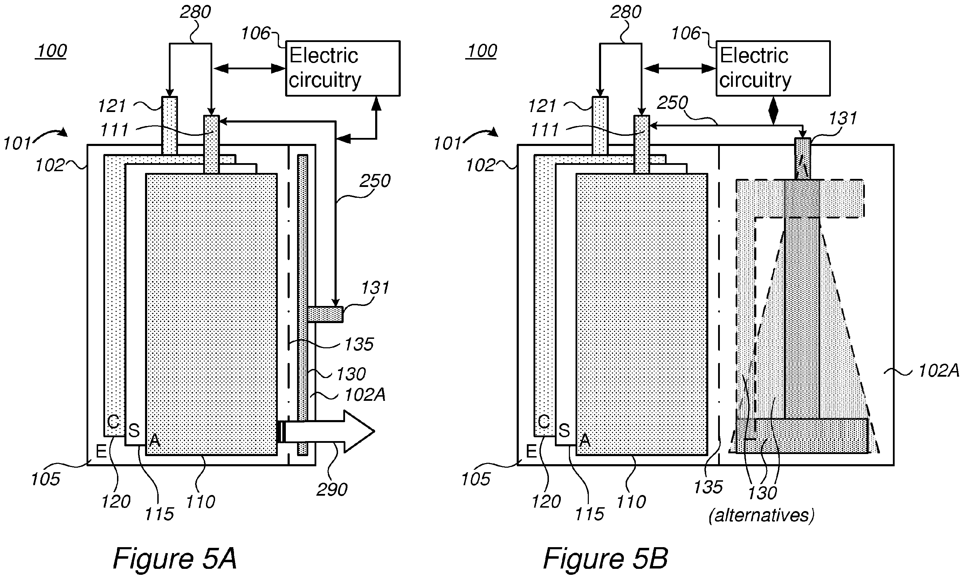

Certain embodiments comprise combination of configurations illustrated in **Figures 3A-3C****,** e.g., both anode(s) **110** and cathode(s) **120** may be lithiated (and/or provided with metal ions **210B** for SEI formation on the anodes) from same or different metal ion source(s) **130,** either being carried out externally (as illustrated e.g., in **Figures 5A, 5B****,** **9** and **10**) and/or internally (see e.g., **Figures 6-8** below).

It is further noted that in various embodiments, lithiation **210A** and/or provision of metal ions **210B** may be carried out fully before formation process **280,** lithiation **210A** and/or provision of metal ions **210B** may be carried out partly before formation process **280,** and possibly continue during a first, second and/or later cycles of formation process **280.** The relative timing, metal ion selection and configuration of metal ion source **130** may be adjusted to optimize the structure of the formed SEI and to improve the stability of batteries **101.**

It is noted that anode(s) **110** may be pre-lithiated and/or lithiated **210A,** and/or cathode(s) **120** may be lithiated **210D** using the following embodiments. Embodiments referring to anodes **110** may be re-configured to be applicable to cathode(s) **120** and vice versa. Any of the disclosed embodiments may be applied to any electrode in battery **101.**

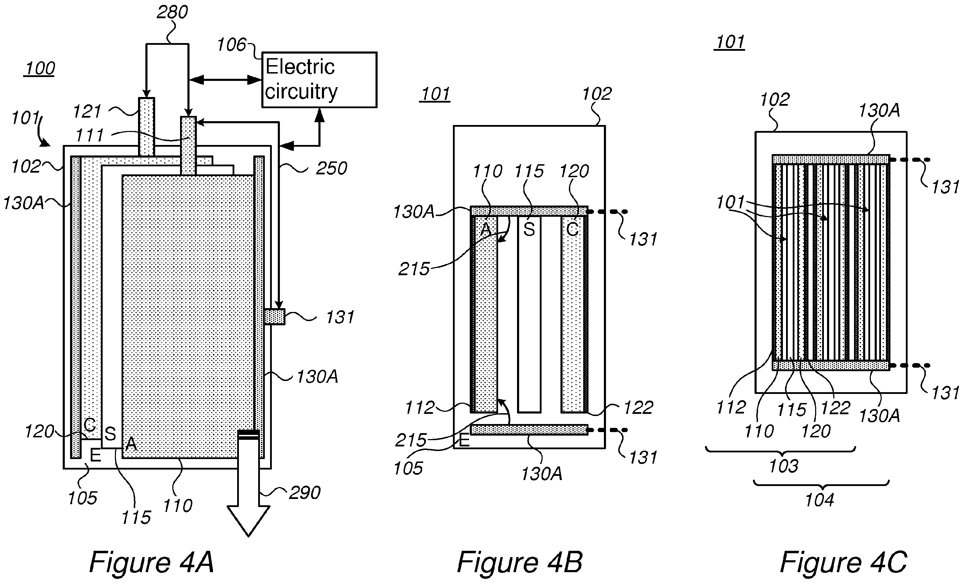

**Figures 4A-4C** are high level schematic illustrations of systems **100** and battery configurations **101** having various metal ion sources **130.** In various embodiments, metal ion source **130** (e.g., lithium source) may be configured as pellets or beads illustrated in **Figures 6, 7A-7B** and **8** and/or as rods, bars, sheets or wires illustrated in **Figures 3A-3B** and **4A-4C.** Pellets, beads, rods, bars or sheets do not belong to the present invention. For example, **Figure 4A** illustrates schematically one or more elongated metal ion sources **130A** (e.g., lithium source) positioned along anodes **110** and **Figure 4B** illustrates schematically one or more elongated metal ion sources **130A** positioned perpendicularly to anodes **110** (SEI formation **215,** possibly as a result of lithium ion movements from prelithiation **210A,** is indicated schematically by arrows). Current collectors **112, 122** are depicted for anode **110** and cathode **120,** respectively, e.g., in non-limiting examples, anode current collector **112** may be made of copper and cathode current collector **112** may be made of aluminum. Applying the specified voltage between anodes **110** and contact(s) **131** of metal ion source **130** are indicated schematically as electric connection and voltage application **250.** Metal ion sources **130** may, in certain embodiments, be used without contacts and application of external voltage to supply metal ions via spontaneous chemical reaction upon contact with anode(s) **110** and/or cathode(s) **120.** Alternatively, or complementarily, contacts **131** (illustrated in broken lines to indicate they are optional) may be connected to metal ion source **130** to provide metal ions to anode(s) **110** and/or cathode(s) **120** electrochemically, in a controllable manner, by application of corresponding voltages between metal ion sources **130** and anode(s) **110** and/or cathode(s) **120.**

**Figure 4C** illustrates schematically one or more elongated metal ion sources **130A** positioned perpendicularly to a cell stack **104** of alternating anodes **110,** separators **115** and cathodes **120,** cell stack **104** being composed of multiple cells **103,** each cell **103** comprising one set of anode **110,** separator **115** and cathode **120,** with their corresponding current collectors **112, 122,** electrolyte **105** and associated structures.

In various embodiments, metal ion source **130A** (e.g., lithium source) may be spatially associated with one or more anode **110** and/or with one or more cathode **120** of stack **104,** and be positioned to optimize the movement of lithium therefrom to anode **110.** For example, metal ion source **130A** may be positioned to minimize a distance to anodes **110,** to provide as uniform as possible metal ion movement thereto (e.g., of any of Li⁺, Mg⁺⁺, Na⁺ etc.), and/or to enhance the stability of the formed SEI.

Contacts **131** (illustrated in broken lines to indicate they are optional) may be connected to metal ion source **130** to provide metal ions to anode(s) **110** and/or cathode(s) **120** electrochemically, in a controllable manner, by application of corresponding voltages between metal ion sources **130** and anode(s) **110** and/or cathode(s) **120.**

**Figures 5A** and **5B** are high level schematic illustrations of systems **100** and battery configuration **101** having removable metal ion sources **130,** according to some embodiments of the invention. In certain embodiments, which do not belong to the present invention, metal ion source **130** may be configured to be removable from pouch cover **102** during degassing **290** of battery **101** following formation process **280.** For example, metal ion sources **130** may be part of a tab **102A** of pouch **102** which is separable from the main body of pouch **102,** e.g., along a tearing line **135,** as illustrated schematically in **Figures 5A** and **5B****.** In various embodiments, removal of metal ion source **130** may be carried out during degassing **290** (e.g., removal of wire-shaped metal ion source **130** through a degassing hole) and does not require an additional process stage. **Figures 5A** and **5B** further illustrate various, non-limiting configurations of shapes and proportions of metal ion source **130,** such as e.g., any of a strap, a rod or a bar (**Figure 5A**), T shape, L shape and triangle (illustrated as alternatives in **Figure 5B****,** all attached to tab **131**), all not belonging to the present invention, which may have different orientations and possibly multiple tabs **131,** to improve any of the prelithiation process, its kinetics, and the homogeneity of the resulting surface of the anode. Cathode lithiation **210D** may be carried out in similar configurations, operated during or after formation, with respect to lithium-depleted cathodes. Applying the specified voltage between anodes **110** and contact(s) **131** of metal ion source **130** - illustrated as a non-limiting example, may be modified to lithiate cathode **120** via contacts **121** - are indicated schematically as electric connection and voltage application **250.**

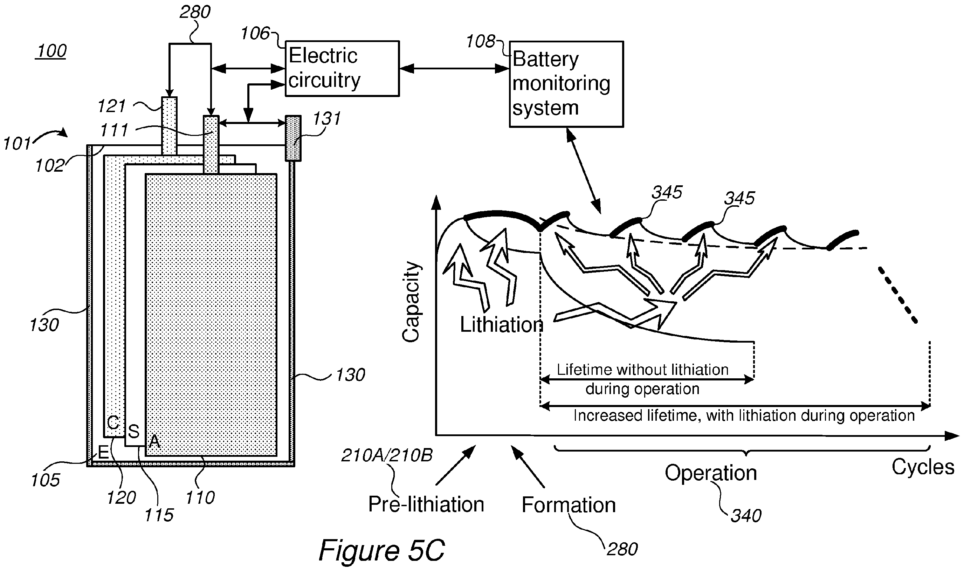

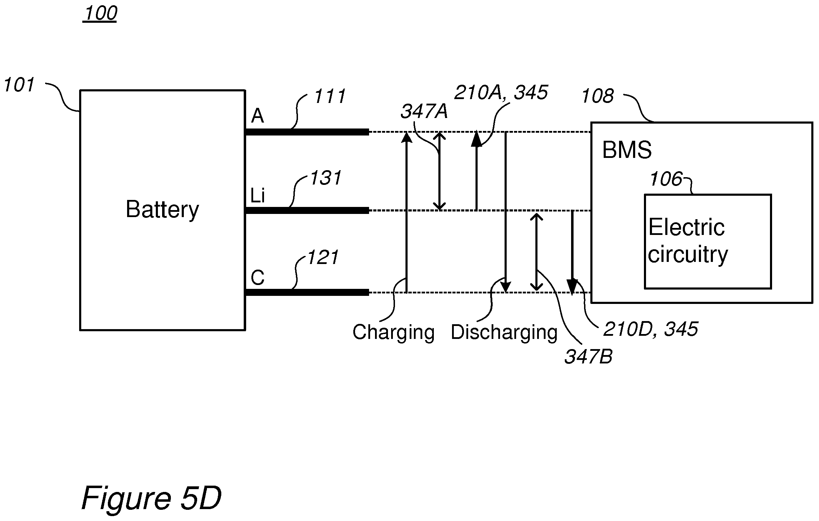

**Figures 5C** and **5D** are high level schematic illustrations of system and battery configurations for lithiation during operation, according to some embodiments of the invention. **Figure 5C** illustrates schematically effects of lithiation during operation on the battery's SoH during operation, while **Figure 5D** illustrates schematically control parameters over lithiation during operation, as described below.

Alternatively, or complementarily to regulating metal ions levels **210B** and/or pre-lithiation **210A** and/or lithiation during the formation process **280** described herein, lithiation may be carried out during operation stages **340.** By incorporating lithium source **130** within pouch **102** of battery **101,** additional lithium may be provided into the cell during operation to compensate for depletion of lithium in the cell during various processes involved in operation **340,** such as charging and/or discharging cycles in which lithium may be consumed by further SEI formation, electrolyte decomposition, lithium fixation in the anode and/or in the cathode etc. Contact **131** may be operated with respect to contacts **111** and/or **121** of anodes **110** and cathodes **120,** respectively, to deliver additional lithium into the cell in a pre-programed fashion (e.g., a certain amount after every certain number of cycles) and/or under specified circumstance - such as e.g., indications of a battery management system (BMS) **108** associated with battery **101** of specified declines in capacity, increases in resistance, or any other state of health (SoH) parameters. Pulses of lithiation **345** are shown schematically in **Figure 5C** to illustrate schematically the reduction in capacity decline of the battery due to applied lithiation **345,** leading to increased lifetime, which may reach 50%, 100% or even more with respect to the lifetime of battery **101** without lithiation pulses **345** during operation **340.** It is noted that lithiation during operation **340** may be carried out continuously, on-demand and/or in a pulsed patterned, the latter mode illustrated in a non-limiting manner in **Figure 5C****.**

Systems **100** may comprise a cell stack for lithium ion batteries **101,** comprising alternating anodes **110,** separators **115** and cathodes **120** packaged in pouch cover **102** (the anodes and cathodes being electrodes of the cell stack), lithium source **130** within pouch cover **102,** having external contact **131** and being in fluid communication with anodes **110,** and electric circuitry **106,** configured to lithiate, electrochemically, anodes **110** by applying specified voltage between anodes **110** and lithium source **130** in pouch cover **102** via its contact **131,** during operation of lithium ion battery **101** and controllably with respect to a state of health (SoH) thereof.

In certain embodiments, systems **100** may comprise a cell stack for lithium ion batteries **101,** comprising alternating anodes **110,** separators **115** and cathodes **120** packaged in pouch cover **102** (the anodes and cathodes being electrodes of the cell stack), lithium source **130** within pouch cover **102,** having external contact **131** and being in fluid communication with cathodes **120,** and electric circuitry **106,** configured to lithiate, electrochemically, cathodes **120** by applying specified voltage between cathodes **120** and lithium source **130** in pouch cover **102** via its contact **131,** during operation of lithium ion battery **101** and controllably with respect to a state of health (SoH) thereof.

In certain embodiments, systems **100** are configured to lithiate anodes **110** and/or cathode(s) **120** selectively, according to SoH parameters of battery **101** (e.g., specified voltage drop, specified capacity fade, specified rise in resistance, specified energy throughput - any of which with respect to predefined thresholds.

As illustrated schematically in **Figure 5D****,** contacts **111, 121, 131** of anodes **110,** cathodes **120** and lithium source **130,** respectively, may be used for operating battery **101,** lithiating anodes **110** and/or cathodes **120** (denoted as stages **210A, 210D,** respectively, by delivering lithiation pulses **345**) as well as monitoring anodes **110** and/or cathodes **120** with respect to lithium source **130** (indicated as stages **347A, 347B,** respectively). Either or both electric circuitry **106** or of BMS **108** may perform or be involved in any of these functions. In certain embodiments, electric circuitry **106** may be realized as part of BMS **108** (as illustrated e.g., in **Figure 5D**). In certain embodiments, electric circuitry **106** may be separated from BMS **108** and in communication therewith (as illustrated e.g., in **Figure 5C**). Any of these configurations may be applicable in any of the embodiments presented above.

In any of the embodiments, systems **100** may comprise BMS **108,** configured to monitoring the SoH of lithium ion battery **101** and to control electric circuitry **106** to carry out the lithiating upon detected specified decrease in the SoH. For example, BMS **108** may be further configured to distinguish, based on the monitored SoH, if anodes **110** or cathodes **120** are to be lithiated as the at least one of the electrodes, and to control electric circuitry **106** accordingly. BMS **108** may be further configured to measure a voltage between lithium source **130** and anodes **110** after charging (indicated schematically be arrow **347A**) and/or cathodes **120** after discharging (indicated schematically be arrow **347B**), and to control electric circuitry **106** accordingly.

In certain embodiments, BMS **108** may be configured to lithiate any of anodes **110** or cathodes **120,** according to any specified criterion, and at any stage of charging or discharging.

**Figure 6** is a high level schematic illustration of battery configuration **101**, not belonging to the present invention, having metal ion sources **130A** (e.g., lithium sources) as beads adjacent to anode(s) **110,** according to some embodiments of the invention. Metal ion source **130A** (e.g., lithium source) may comprise any number of beads, positioned in cells **103** and stacks **104,** and may have any form. For example, metal ion source **130A** may comprise beads positioned adjacent or onto anode(s) **110.** In certain embodiments, at least some, or all, of metal ion source beads **130A** (e.g., lithium source beads, or possibly mixed metal source beads of various metals) may be left in battery **101** during operation, and provide additional lithium supply to increase cycle life by providing lithium which is consumed internally during operation. In certain embodiments, at least some of metal ion source beads **130A** may be removed, e.g., during degassing **290** (possibly preferentially with respect to the type of metal). It is noted that in case of metal ion source as beads or other small elements within pouch **102,** prelithiation may be carried out electrochemically on the surface of anode **110** without establishment of an external electrical circuit (e.g., without tab(s) **131**). Metal ion sources **130** may, in certain embodiments, be used without contacts and application of external voltage to supply metal ions via spontaneous chemical reaction upon contact with anode(s) **110** and/or cathode(s) **120.** Alternatively or complementarily, contacts **131** (illustrated in broken lines to indicate they are optional) may be connected to metal ion source **130** to provide metal ions to anode(s) **110** and/or cathode(s) **120** electrochemically, in a controllable manner, by application of corresponding voltages between metal ion sources **130** and anode(s) **110** and/or cathode(s) **120.**

**Figures 7A** and **7B** are high level schematic illustrations of battery configuration **101**, not belonging to the present invention, having metal ion sources **130A** which are incorporated in current collector(s) **112, 122,** according to some embodiments of the invention. In certain embodiments, metal ion source beads **130A** may be incorporated in one or more of anode and/or cathode in current collector(s) **112, 122,** respectively. For example, it is noted that in cell stack **104,** cathode current collector(s) **122** are adjacent to anode(s) **110** of adjacent cell **103,** so that incorporation of metal ion source **130A** in cathode current collector(s) **122** may provide close lithium movement paths to anode(s) **110** in adjacent cells **103.** In certain embodiments, incorporation of metal ion source **130A** in current collector(s) **112** and/or **122** may be carried out by mixing and/or alloying lithium in current collector material, such as lithium copper mixture and/or alloy for anode current collector(s) **112** and/or as lithium aluminum mixture and/or alloy for cathode current collector(s) **122.**

Metal ion sources **130** may, in certain embodiments, be used without contacts and application of external voltage to supply metal ions via spontaneous chemical reaction upon contact with anode(s) **110** and/or cathode(s) **120.** Alternatively, or complementarily, contacts **131** (illustrated in broken lines to indicate they are optional) may be connected to metal ion source **130** to provide metal ions to anode(s) **110** and/or cathode(s) **120** electrochemically, in a controllable manner, by application of corresponding voltages between metal ion sources **130** and anode(s) **110** and/or cathode(s) **120.**

It is emphasized that different configurations of metal ion source **130A** within batteries **101** may be combined to form additional embodiments. Also, any of the embodiments disclosed herein may be applied for any configuration of cell stacks **104,** and while most illustrations present single cells **103** with one anode **110** and one cathode **120,** this is done solely for explanatory purposes, and is not limiting the application of the invention to full cell stacks **104** and corresponding batteries **101.**

**Figure 8** is a high level schematic illustration of system configuration **100,** not belonging to the present invention, with fluid flow regulation of metal ion levels in one or more electrode, with flows indicated as inflow **140** and outflow **145,** according to some embodiments of the invention. In certain embodiments, regulation of metal ion levels may be carried out from external metal ion source **130B** (shown schematically) by fluid provision **140** of lithium and/or any of Mg, Na, Mg⁺⁺, Na⁺ etc., which may be used to continuously replace electrolyte **105** prior, or during formation process **280.** In certain embodiments, the regulation of metal ion levels may comprise pre-lithiation **210A** (see **Figure 1**) of anodes **110** and/or provision of metal ions **210B** (see **Figure 1**) to anodes **110.** In either case, provided Li, Mg, Na, Li⁺, Mg⁺⁺ and/or Na⁺ may contribute to the formation of SEI on anode(s) **110.** In certain embodiments, the regulation of metal ion levels may comprise lithiation **210D** (see **Figure 1**) of cathodes **120** after or during formation steps.

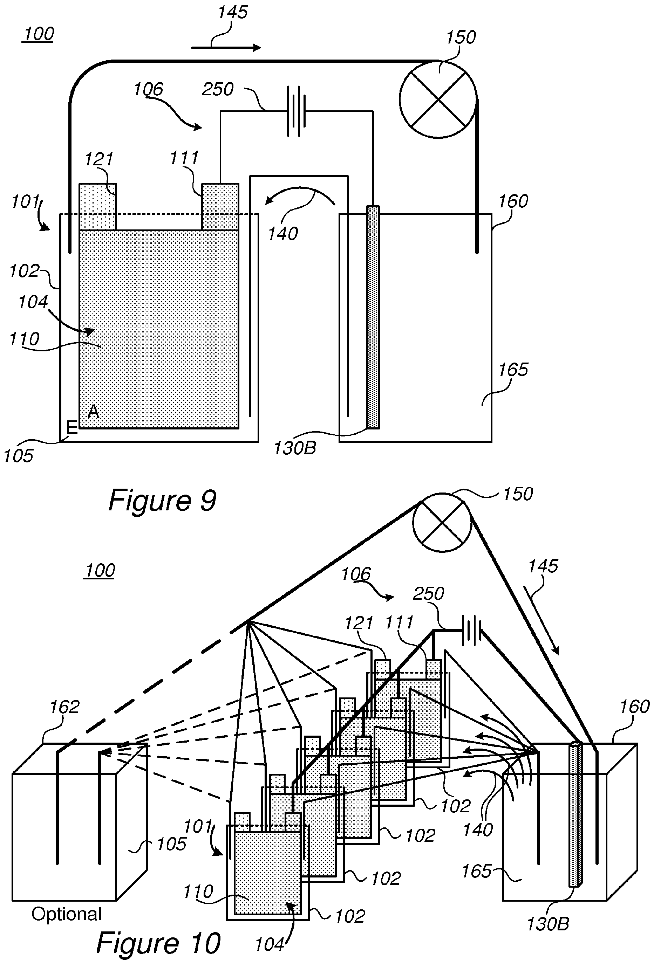

**Figures 9** and **10** are high level schematic illustrations of systems **100** with fluid flow regulation of metal ion levels in one or more electrode, with flows indicated as inflow **140** and outflow **145,** according to some embodiments of the invention. System **100** may comprise at least one cell stack **104** for lithium ion batteries **101,** each cell stack **104** comprising alternating anodes **110,** separators **115** and cathodes **120** packaged in pouch cover **102,** at least one electrolyte reservoir **160,** having metal ion source(s) therein (e.g., in fluid **165** such as in electrolyte fluid), in fluid connection to cell stack(s) **104** in respective pouch cover **102,** a pump **150** configured to maintain circular flow **140, 145** of electrolyte **165** between cell stack(s) **104** in pouch cover **102** and electrolyte reservoir **160,** and electric circuitry **106** configured to apply specified voltage between anode(s) **110** of cell stack(s) **104** and the metal ion source(s) (comprising any of Li, Mg, Na, Li⁺, Mg⁺⁺, Na⁺ etc.,) in electrolyte reservoir **160,** to regulate the level(s) of metal ion(s) in any of the components of batteries **101.** In certain embodiments, the regulation of metal ion levels may comprise pre-lithiation **210A** (see **Figure 1**) of anodes **110** and/or provision of metal ions **210B** (see **Figure 1**) to anodes **110.** In either case, provided Li, Mg, Na, Li⁺, Mg⁺⁺ and/or Na⁺ may contribute to the formation of SEI on anode(s) **110.** In certain embodiments, the regulation of metal ion levels may comprise limitation **210D** (see **Figure 1**) of cathodes **120** after or during formation steps. Applying the specified voltage between anodes **110** and contact(s) **131** of metal ion source **130B** - illustrated as a non-limiting example, may be modified to lithiate cathode **120** via contacts **121** - are indicated schematically as electric connection and voltage application **250.**

In certain embodiments, electrolyte reservoir **160** may comprise at least two electrolyte reservoirs **160, 162,** of which at least one (**160**) may be configured to regulate metal ion levels (**210B**) and/or to pre-lithiate **210A** (and/or provide metal ions to) anodes **110** and form the SEI thereon, and at least another one (**162**) may be configured to load pouch cover **102** with electrolyte **105** for operation of lithium ion battery **101** after pre-lithiation **210A,** possibly after formation **280.** Formation process **280** may be carried out during or after the metal ions are regulated **210B,** e.g., during prelithiation **210A** and/or after prelithiation **210A** is completed. Different, possibly multiple electrolyte reservoir **160, 162** may be used to provide different types and/or proportions of metal ions, possibly in different pre-lithiation and/or formation steps.

In certain embodiments, cell stack(s) **104** may comprise multiple cell stacks **104** in multiple batteries **101,** and electrolyte reservoir(s) **160, 162** may be used simultaneously and commonly for all cell stacks **104** to carry out the regulation of metal ion levels and possibly electrolyte replacement.

**Figure 11** is a high-level flowchart illustrating a method **200**, not belonging to the present invention. The method stages may be carried out with respect to systems **100** and batteries **101** described above, which may optionally be configured to implement method **200.** Method **200** may comprise stages for producing, preparing and/or using systems **100** and batteries **101,** such as any of the following stages, irrespective of their order. Certain embodiments comprise computer program products comprising a computer readable storage medium having computer readable program embodied therewith and configured to carry out of the relevant stages of method **200.** Method **200** may comprise stages for producing, preparing, operating, and/or using systems **100** and batteries **101** described above, such as any of the following stages, irrespective of their order.

Method **200** comprises regulating a level of metal ions in at least one electrode (e.g., anode(s) and/or cathode(s)) in a lithium ion battery, when the at least one electrode is in a pouch of the lithium ion battery (stage **210**), wherein the regulation of metal ions level is carried out electrochemically between the at least one electrode and a metal ion source which is an internal and/or an external metal ions source containing e.g., Li, Mg and/or Na (stage **212**), prior to, and possibly during a formation process of the lithium ion battery, and possibly prior to and/or during the operation of the battery (stage **213**). Regulating the metal ion levels may be carried out in situ, within the battery pouch, on anode(s) and/or cathode(s) of a cell stack, sequentially or simultaneously, from a metal ion source internal, in the pouch. Certain embodiments of providing metal ions to the anodes before the formation process is carried out may be referred to as a pre-metallization stage. Metal ions such as Mg⁺⁺ and Na⁺ may be provided, possibly in addition to Li⁺, as well as metal atoms e.g., Li, Mg, Na.

In certain embodiments, regulation **210** may comprise any of the following: pre-lithiating the anodes (as the electrodes, the anodes may comprise anode material particles of at least one of Si, Ge and Sn which may be polymer-coated) from the at least one lithium source (as the metal ion source) prior to the formation process (stage **220**); lithiating the anodes from the at least one lithium source during the formation process (stage **225**), and possibly also during operation from at least rudiments of the at least one lithium source which are left in the pouch during operation (stage **227**); forming at least part of the SEI on the anodes from magnesium and/or sodium from the at least one magnesium and/or sodium source (as the metal ion source, possibly in combination with lithium), at least prior to the formation process (stage **230**); and/or lithiating the cathodes (as the electrodes) from the at least one lithium source (as the metal ion source) upon lithium depletion from the cathodes, during and/or after the formation process (stage **240**).

Method **200** may comprise connecting, electrically, electrode(s) to the metal ion source and applying a voltage therebetween (stage **250**). Pre-lithiating and/or lithiating the anodes may be carried out by electrically connecting the anode(s) to the metal ion source and applying a voltage therebetween. Lithiating the cathodes may be carried out by electrically connecting the at least one cathode (when it is a depleted state, having part of its original lithium content) to the metal ion source and applying a voltage therebetween.

Pre-lithiating and/or lithiation of the anode(s) **220, 225,** respectively, may be configured to at least partly form, controllably, an SEI on the anode(s), during a pre-lithiation, pre-metallization (referring e.g., to provision of Mg and/or Na ions, alone or in addition to Li ions) and/or during the formation process, utilizing the metal ion source (stage **260**). In certain embodiments, lithiating **225** may be configured to compensate for lithium consumption during the formation process, e.g., from the cathode(s) - for example by adding lithium to the cathode **240** during the formation process, from the lithium source.

Method **200** may further comprise incorporating metal lithium in a pouch comprising a cell stack and electrolyte (stage **270**) and carrying out any of stages **210** to **240** using the internal lithium source, at least partly. Correspondingly, method **200** may comprise pre-lithiating anode(s) of the cell stack electrochemically by electric connection thereof to the metal lithium (and/or Mg, Na, etc.) incorporated in the pouch (stage **272**) and/or lithiating cathode(s) of the cell stack electrochemically by electric connection thereof to the metal lithium (and/or Mg, Na, etc.) incorporated in the pouch (stage **274**).

Method **200** may further comprise performing the formation process, with anodes and cathodes as the cell electrodes (stage **280**). Method **200** may further comprise degassing the pouch following the formation process (stage **290**). Method **200** may further comprise removing the metal ion source after pre-lithiation **210** during degassing phase **250** following formation process **240** (stage **292**). In certain embodiments, method **200** may comprise removing residual lithium during the degassing phase (stage **294**), and possibly re-using the removed residual metal lithium (stage **296**).

Anode pre-lithiation **220** may be carried out prior to formation process **280** (stage **302**) and/or anode lithiation **225** may be carried out during formation process **280** (stage **304**). It is noted that lithiation during the formation process may augment pre-lithiation applied before the formation process. Additional lithiation during the formation process may be configured to compensate for lithium consumption during the formation process, e.g., from the cathode(s).

Method **200** may further comprise optimizing a shape and/or a position of the metal ion source within the pouch (stage **310**), possibly optimizing a position of the metal ion source in the stack, according to the efficiency of metal ions movement (stage **315**), e.g., with respect to pre-lithiation **220,** and/or metal ion regulation and/or lithiation of any of stages **225-240.**

Method **200** may comprise associating, at least partly, the metal ion and/or lithium source with the anode(s) in the stack (stage **320**) and/or with the cathode(s) in the stack (stage **322**). In certain embodiments, method **200** may comprise incorporating metal lithium, as a lithium source, and/or other metal mixtures or alloys of e.g., Mg, Na, Li, in at least one current collector (stage **330**), e.g., in at least one anode current collector and/or in at least one cathode current collector, e.g., in mixture with copper and/or as a copper alloy in the former case, and/or in mixture with aluminum and/or as an aluminum alloy in the latter case.

Method **200** may comprise incorporating metal lithium in a small quantity in the pouch, without removal thereof from the pouch (stage **335**). Incorporated lithium may be thus used to at least partly compensate for losses of lithium during operation of the battery. Method **200** may comprise operating the lithium ion battery (stage **340**). Method **200** may comprise incorporating metal lithium in wire form in the pouch and carrying out lithiation during operation (stage **342**), to compensate for depletion of lithium in the cell during various processes involved in operation, such as charging and/or discharging cycles in which lithium may be consumed by further SEI formation, electrolyte decomposition, lithium fixation in the anode and/or in the cathode etc. Lithiation **342** may be continuous or intermittent, and possibly be related to SoH parameters of the battery (stage **345**).

Method **200** may further comprise monitoring the SoH of the lithium ion battery and carrying out the lithiating upon detected specified decrease in the SoH (stage **347**), e.g., using SoH parameters such as reduction in capacity, rise in resistance, decreasing maximal voltage etc.). In certain embodiments, monitoring **347** may comprise either or both monitoring the anodes and monitoring the cathodes with respect to lithium source itself (see e.g., **Figure 5D**), e.g., by measuring the anodes and/or cathodes with respect to the lithium source (stage **348**). Method **200** may further comprise lithiating anodes after charging and/or cathodes after discharging of the cell (stage **349**), or possibly during partial charging and/or discharging, respectively. For example, the selection of anodes and/or cathodes for lithiation may be carried out according to a voltage level between the anodes and the lithium source after the charging and/or according to a voltage level between the cathodes and the lithium source after the discharging.

Method **200** may comprise positioning the metal ion source along and/or perpendicularly to a cell stack of the battery (stage **350**). In certain embodiments, method **200** may comprise positioning the metal ion source in a removable part of the pouch (stage **352**). In certain embodiments, method **200** may comprise associating, spatially, the metal ion source with opening(s) for degassing (stage **355**).

Method **200** may comprise connecting electrolyte reservoir(s), having metal ion source therein, in fluid connection to the cell stack in the pouch cover (stage **360**) and carrying out any of the metal ion regulation stages via the fluid connection. In certain embodiments, method **200** may comprise pumping electrolyte between the reservoir(s) and the cell stacks in the pouches (stage **365**), possibly with different electrolyte reservoir(s) providing different electrolyte compositions, such as one or more electrolyte compositions for pre-lithiation, for SEI formation, for consequent lithiation, for filling operative electrolyte for the operation cycles etc. For example, method **200** may comprise maintaining circular flow of electrolyte between the cell stack in the pouch cover and the electrolyte reservoir(s) (stage **370**), see e.g., flows **140, 145** in **Figures 9** and **10****.**

Method **200** may further comprise applying specified voltage between the anodes and the metal ion source in the electrolyte reservoir(s) (stage **380**). Method **200** may further comprise configuring at least one electrolyte reservoir to provide the pre-lithiation and at least another electrolyte reservoir to load the pouch cover with electrolyte for operation of the lithium ion battery (stage **390**). Method **200** may comprise applying the metal ion regulation (e.g., pre-lithiation and/or lithiation) simultaneously to multiple cell stacks with the electrolyte reservoir(s) used commonly for all the cell stacks (stage **400**).

In various embodiments, regulation of metal ions level **210** may be carried out in any of constant current (CC), constant voltage (CV), and/or constant current, constant voltage (CCCV) modes, as well as in dynamic current *(dI*/*dt≠0)* and/or dynamic voltage *(dV*/*dt≠0)* modes alone or in combination. Currents may range from 10µA to 10mA and voltage may vary from 400mV to 20mV. Prelithiation time may be in scales of a few hours to a few weeks. Temperature may vary from 25°C to 70°C.

In certain embodiments, anode(s) **110** may comprise anode active material particles and additive(s) such as binder(s) (e.g., polyvinylidene fluoride (PVDF), styrene butadiene rubber (SBR) or any other binder), plasticizer(s) and/or conductive filler(s), mixed in water-based or organic solvent(s). The anode slurry may be dried, consolidated and positioned in contact with current collector **112.** Anode active material particles may comprise particles of any of graphite, graphene, metalloids such as silicon, germanium and/or tin, and/or possibly particles of aluminum, lead and/or zinc. Anode active material particles may be configured to receive lithium during charging and release lithium during discharging, reversibly over a large number of cycles, without mechanical damage to anode(s) **110.** The anode active material particles may be composite materials, e.g., coated particles, shell-core particles etc. The anode active material particles may comprise coatings such as conductive polymers, lithium polymers, possibly borate and/or phosphate salt(s) (forming e.g., B₂O₃, P₂O₅ etc. on the surface of anode active material particles), bonding molecules which may interact with electrolyte **105** (and/or ionic liquid additives thereto) and/or various nanoparticles (e.g., B₄C, WC, VC, TiN) which may be attached to the anode material particles in anode preparation processes such as ball milling. The size range of the anode active material particles may be at an order of magnitude of 100nm, and/or possibly in the order of magnitude of 10nm or 1µ. The size range of nanoparticles attached to the anode active material particles may be at an order of magnitude lower than that of the anode material particles, e.g., lOnm, and/or possibly 100nm (the latter in case of larger anode material particles).

In certain embodiments, cathode(s) **120** may comprise materials based on layered, spinel and/or olivine frameworks, and comprise various compositions, such as LCO formulations (based on LiCoO₂), NMC formulations (based on lithium nickel-manganese-cobalt), NCA formulations (based on lithium nickel cobalt aluminum oxides), LMO formulations (based on LiMn₂O₄), LMN formulations (based on lithium manganese-nickel oxides) LFP formulations (based on LiFePO₄), lithium rich cathodes, and/or combinations thereof. Separator(s) **115** may comprise various materials, such as polyethylene (PE), polypropylene (PP) or other appropriate materials.

Examples for electrolyte **105** may comprise liquid electrolytes such as ethylene carbonate (EC), diethyl carbonate (DEC), propylene carbonate (PC), fluoroethylene carbonate (FEC), ethyl methyl carbonate (EMC), dimethyl carbonate (DMC), vinylene carbonate (VC), possibly tetrahydrofuran (THF) and/or its derivatives, and combinations thereof; and/or solid electrolytes such as polymeric electrolytes such as polyethylene oxide, fluorine-containing polymers and copolymers (e.g., polytetrafluoroethylene), and combinations thereof. Electrolyte **105** may comprise lithium electrolyte salt(s) such as LiPF₆, LiBF₄, lithium bis(oxalato)borate, LiN(CF₃SO₂)₂, LiN(C₂F₅SO₂)₂, LiAsF₆, LiC(CF₃SO₂)₃, LiClO₄, LiTFSI, LiB(C₂O₄)₂, LiBF₂(C₂O₄), tris(trimethylsilyl)phosphite (TMSP) and combinations thereof. Ionic liquid(s) additives may be added to electrolyte **105.**

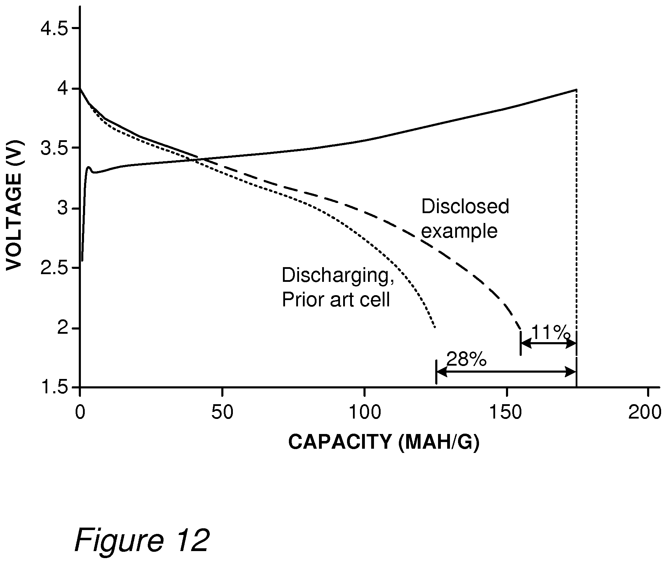

**Figure 12** provides an example of results illustrating the improved operation of batteries **101** resulting from systems **100** and/or methods **200,** according to some embodiments of the invention. **Figure 12** illustrates schematically a charging curve (solid line) and discharging curves of a first cycle, for prior art full cell (dotted line) and for full cell **101** (dashed line) with pre-lithiated anode. In the presented example, concerning metalloid systems normalized to NCA cathodes, the capacity loss (full cycle equivalent, FCE) is improved from ca. 28% (leaving ca. 72% capacity) in the prior art full cell (dotted line) to ca. 11% (leaving ca. 89% capacity) in full cell **101** with pre-lithiated anode (dashed line).

Certain embodiments comprise computer program products comprising a computer readable storage medium having computer readable program embodied therewith and configured to monitor, control and/or operate systems **100** and batteries **101** to provide the regulation of metal ions and/or lithiation steps described above, such as pre-lithiation, lithiation during formation and/or lithiation during operation, possibly in conjuncture with the carrying out of the formation processes and/or operating batteries **101.** Certain embodiments comprise battery management systems comprising computer readable program configured to operate any of the method stages disclosed above.

Aspects of the present invention are described above with reference to flowchart illustrations and/or portion diagrams of methods, apparatus (systems) and computer program products according to embodiments of the invention. It will be understood that each portion of the flowchart illustrations and/or portion diagrams, and combinations of portions in the flowchart illustrations and/or portion diagrams, can be implemented by computer program instructions. These computer program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart and/or portion diagram or portions thereof.

These computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or portion diagram or portions thereof.

The computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or portion diagram or portions thereof.

The aforementioned flowchart and diagrams illustrate the architecture, functionality, and operation of possible implementations of systems, methods and computer program products according to various embodiments of the present invention. In this regard, each portion in the flowchart or portion diagrams may represent a module, segment, or portion of code, which comprises one or more executable instructions for implementing the specified logical function(s). It should also be noted that, in some alternative implementations, the functions noted in the portion may occur out of the order noted in the figures. For example, two portions shown in succession may, in fact, be executed substantially concurrently, or the portions may sometimes be executed in the reverse order, depending upon the functionality involved. It will also be noted that each portion of the portion diagrams and/or flowchart illustration, and combinations of portions in the portion diagrams and/or flowchart illustration, can be implemented by special purpose hardware-based systems that perform the specified functions or acts, or combinations of special purpose hardware and computer instructions.

In the above description, an embodiment is an example or implementation of the invention. The various appearances of "one embodiment", "an embodiment", "certain embodiments" or "some embodiments" do not necessarily all refer to the same embodiments. Although various features of the invention may be described in the context of a single embodiment, the features may also be provided separately or in any suitable combination. Conversely, although the invention may be described herein in the context of separate embodiments for clarity, the invention may also be implemented in a single embodiment. Certain embodiments of the invention may include features from different embodiments disclosed above, and certain embodiments may incorporate elements from other embodiments disclosed above. The disclosure of elements of the invention in the context of a specific embodiment is not to be taken as limiting their use in the specific embodiment alone. Furthermore, it is to be understood that the invention can be carried out out or practiced in various ways and that the invention can be implemented in certain embodiments other than the ones outlined in the description above.
The invention is not limited to those diagrams or to the corresponding descriptions. For example, flow need not move through each illustrated box or state, or in exactly the same order as illustrated and described. Meanings of technical and scientific terms used herein are to be commonly understood as by one of ordinary skill in the art to which the invention belongs, unless otherwise defined. While the invention has been described with respect to a limited number of embodiments, these should not be construed as limitations on the scope of the invention, but rather as exemplifications of some of the preferred embodiments. Other possible variations, modifications, and applications are also within the scope of the invention. Accordingly, the scope of the invention should not be limited by what has thus far been described, but by the appended claims.

## Claims

1. A method comprising lithiating electrodes of a lithium ion battery during its operation, carried out electrochemically between the electrodes and a lithium source which is embedded in the battery, and controllably with respect to a state of health (SoH) of the lithium ion battery, said method further comprising:
incorporating the lithium source, having an electric contact connected thereto, within a pouch of the lithium ion battery, wherein the electrodes comprise anodes and/or cathodes of the lithium ion battery and wherein the lithium source is configured as a lithium-containing wire associated with the pouch and in fluid communication with the anodes and/or cathodes.

2. The method of claim 1, further comprising regulating a level of metal ions in the anodes prior to and/or during a formation process of the lithium ion battery.

3. The method of claim 1, further comprising monitoring the SoH of the lithium ion battery and carrying out the lithiating upon detecting a specified decrease in the SoH.

4. The method of claim 3, wherein the monitoring of the battery SoH comprises measuring anode and/or cathode lithiation using the lithium source.

5. The method of any preceding claim, wherein the lithiating comprises lithiating the anodes after charging the battery.

6. The method of any preceding claim, wherein the lithiating is carried out according to a voltage level between the anodes and the lithium source after the charging.

7. The method of any preceding claim, wherein the lithiating comprises lithiating the cathodes after discharging the battery.

8. The method of any preceding claim, wherein the lithiating is carried out according to a voltage level between the cathodes and the lithium source after the discharging.

9. A system comprising:
a cell stack forming a lithium ion battery, comprising alternating anodes, separators and cathodes, packaged in a pouch cover, the anodes and cathodes being electrodes of the cell stack,
a lithium source within the pouch cover, having an external contact and being in fluid communication with at least one of the electrodes, wherein the lithium source is configured as a lithium-containing wire associated with the pouch and in fluid communication with the anodes and/or the cathodes, and
electric circuitry, configured to lithiate, electrochemically, the at least one of the electrodes by applying specified voltage between the at least one of the electrodes and the lithium source in the pouch cover via its contact, during operation of the lithium ion battery and controllably with respect to a state of health (SoH) thereof.

10. The system of claim 9, wherein the lithium-containing wire is in fluid communication with at least one of the electrodes comprises the anodes.

11. The system of claim 9 or 10, wherein the lithium-containing wire is in fluid communication with at least one of the electrodes comprises the cathodes.

12. The system of any of claims 9 to 11, further comprising a battery monitoring system (BMS) configured to monitoring the SoH of the lithium ion battery and control the electric circuitry to carry out the lithiating upon detected specified decrease in the SoH.

13. The system of claim 12, wherein the BMS is further configured to detect, based on the monitored SoH, which of the electrodes is to be lithiated and to control the electric circuitry accordingly.

14. The system of claims 12 or 13, wherein the BMS is further configured to distinguish, based on the monitored SoH, if anodes or cathodes are to be lithiated as the at least one of the electrodes, and to control the electric circuitry accordingly.

15. The system of any of claims 12 to 14, wherein the BMS is further configured to measure a voltage between the lithium source and the anodes after charging and/or the cathodes after discharging, and to control the electric circuitry accordingly.

## Patentansprüche

1. Verfahren, umfassend ein Lithiieren von Elektroden einer Lithiumionenbatterie während ihres Betriebs, das auf elektrochemischem Weg zwischen den Elektroden und einer in die Batterie eingebetteten Lithiumquelle und in Bezug auf einen Gesundheitszustand (State of Health - SoH)) der Lithiumionenbatterie steuerbar ausgeführt wird, wobei das Verfahren ferner umfasst:
Aufnehmen der Lithiumquelle, die einen mit ihr verbundenen elektrischen Kontakt aufweist, innerhalb eines Etuis der Lithiumionenbatterie, wobei die Elektroden Anoden und/oder Kathoden der Lithiumionenbatterie umfassen und wobei die Lithiumquelle als lithiumhaltiger Draht konfiguriert ist, der dem Etui zugeordnet ist und mit den Anoden und/oder Kathoden in Fluidverbindung steht.

2. Verfahren nach Anspruch 1, ferner umfassend ein Regulieren eines Gehalts an Metallionen in den Anoden vor und/oder während eines Bildungsprozesses der Lithiumionenbatterie.

3. Verfahren nach Anspruch 1, ferner umfassend ein Überwachen des SoH der Lithiumionenbatterie und ein Durchführen des Lithiierens, wenn eine spezifizierte Abnahme des SoH erfasst wird.

4. Verfahren nach Anspruch 3, wobei das Überwachen des SoH der Batterie ein Messen einer Anoden- und/oder Kathodenlithiierung unter Verwendung der Lithiumquelle umfasst.

5. Verfahren nach einem der vorhergehenden Ansprüche, wobei das Lithiieren ein Lithiieren der Anoden nach einem Laden der Batterie umfasst.

6. Verfahren nach einem der vorhergehenden Ansprüche, wobei das Lithiieren gemäß einem Spannungspegel zwischen den Anoden und der Lithiumquelle nach dem Laden ausgeführt wird.

7. Verfahren nach einem der vorhergehenden Ansprüche, wobei das Lithiieren ein Lithiieren der Kathoden nach einem Entladen der Batterie umfasst.

8. Verfahren nach einem der vorhergehenden Ansprüche, wobei das Lithiieren gemäß einem Spannungspegel zwischen den Kathoden und der Lithiumquelle nach dem Entladen ausgeführt wird.

9. System, umfassend:
einen Zellenstapel, der eine Lithiumionenbatterie bildet, umfassend alternierende Anoden, Separatoren und Kathoden, die in einer Etuiabdeckung verpackt sind, wobei die Anoden und Kathoden Elektroden des Zellenstapels sind,
eine Lithiumquelle innerhalb der Etuiabdeckung, die einen externen Kontakt aufweist und in Fluidverbindung mit mindestens einer der Elektroden steht, wobei die Lithiumquelle als lithiumhaltiger Draht konfiguriert ist, der dem Etui zugeordnet ist und mit den Anoden und/oder Kathoden in Fluidverbindung steht, und
eine elektrische Schaltung, die dazu konfiguriert ist, durch Anlegen einer spezifizierten Spannung zwischen der mindestens einen der Elektroden und der Lithiumquelle in der Etuiabdeckung über ihren Kontakt während eines Betriebs der Lithiumionenbatterie und steuerbar in Bezug auf einen Gesundheitszustand (SoH) die mindestens eine der Elektroden auf elektrochemischem Weg zu lithiieren.

10. System nach Anspruch 9, wobei der lithiumhaltige Draht in Fluidverbindung mit mindestens einer der Elektroden steht und die Anoden umfasst.

11. System nach Anspruch 9 oder 10, wobei der lithiumhaltige Draht in Fluidverbindung mit mindestens einer der Elektroden steht und die Kathoden umfasst.

12. System nach einem der Ansprüche 9 bis 11, ferner umfassend ein Batterieüberwachungssystem (Battery Monitoring System - BMS), das dazu konfiguriert ist, den Gesundheitszustand (SoH) der Lithiumionenbatterie zu überwachen und die elektrische Schaltung zu steuern, sodass sie das Lithiieren nach einer erfassten, spezifizierten Abnahme der SoH ausführt.

13. System nach Anspruch 12, wobei das BMS ferner dazu konfiguriert ist, basierend auf dem überwachten SoH zu erfassen, welche der Elektroden zu lithiieren ist und die elektrische Schaltung entsprechend zu steuern.

14. System nach Anspruch 12 oder 13, wobei das BMS ferner dazu konfiguriert ist, basierend auf dem überwachten SoH zu unterscheiden, ob Anoden oder Kathoden als die mindestens eine der Elektroden zu lithiieren sind und die elektrische Schaltung entsprechend zu steuern.

15. System nach einem der Ansprüche 12 bis 14, wobei das BMS ferner dazu konfiguriert ist, eine Spannung zwischen der Lithiumquelle und den Anoden nach einem Laden und/oder den Kathoden nach einem Entladen zu messen und die elektrische Schaltung entsprechend zu steuern.

## Revendications

1. Procédé comprenant la lithiation des électrodes d'une batterie au lithium-ion pendant son fonctionnement, effectuée électrochimiquement entre les électrodes et une source de lithium qui est intégrée dans la batterie, et de manière contrôlable relativement à un état de santé (ÉdS) de la batterie au lithium-ion , ledit procédé comprenant en outre :
d'incorporer la source de lithium, ayant un contact électrique connecté à celle-ci, dans une poche de la batterie au lithium-ion, dans laquelle les électrodes comprennent des anodes et/ou des cathodes de la batterie au lithium-ion et dans laquelle la source de lithium est configurée comme un fil contenant du lithium associé à la poche en communication fluide avec les anodes et/ou cathodes.

2. Procédé selon la revendication 1, comprenant en outre la régulation d'un niveau d'ions métalliques dans les anodes avant et/ou pendant un processus de formation de la batterie lithium-ion.

3. Procédé selon la revendication 1, comprenant en outre la surveillance de l'ÉdS de la batterie lithium-ion et la réalisation de la lithiation lors de la détection d'une diminution spécifiée de l'ÉdS.

4. Procédé selon la revendication 3, dans lequel la surveillance de l'ÉdS de la batterie comprend la mesure de la lithiation anodique et/ou cathodique à l'aide de la source de lithium.

5. Procédé selon l'une quelconque des revendications précédentes, dans lequel la lithiation comprend la lithiation des anodes après un chargement de la batterie.

6. Procédé selon l'une quelconque des revendications précédentes, dans lequel la lithiation est effectuée selon un niveau de tension entre les anodes et la source de lithium après la charge.

7. Procédé selon l'une quelconque des revendications précédentes, dans lequel la lithiation comprend la lithiation des cathodes après une décharge de la batterie.

8. Procédé selon l'une quelconque des revendications précédentes, dans lequel la lithiation est effectuée selon un niveau de tension entre les cathodes et la source de lithium après la décharge.

9. Système comprenant :
un empilement de cellules formant une batterie lithium-ion, comprenant des anodes, des séparateurs et des cathodes alternés, conditionnés dans un couvercle de poche, les anodes et cathodes étant des électrodes de l'empilement de cellules,
une source de lithium à l'intérieur du couvercle de la poche, ayant un contact externe et étant en communication fluide avec au moins une des électrodes, dans lequel la source de lithium est configurée comme un fil contenant du lithium associé à la poche et en communication fluide avec les anodes et/ou les cathodes, et
des circuits électriques, configurés pour lithier, électrochimiquement, la au moins une des électrodes en appliquant une tension spécifiée entre la au moins une des électrodes et la source de lithium dans le couvercle de la poche via son contact, pendant le fonctionnement de la batterie au lithium-ion et de manière contrôlable relativement à son état de santé (ÉdS).

10. Système selon la revendication 9, dans lequel le fil contenant du lithium est en communication fluide avec au moins une des électrodes comprenant les anodes.

11. Système selon la revendication 9 ou 10, dans lequel le fil contenant du lithium est en communication fluide avec au moins une des électrodes comprenant les cathodes.

12. Système selon l'une quelconque des revendications 9 à 11, comprenant en outre un système de surveillance de batterie (SSB) configuré pour surveiller l'ÉdS de la batterie au lithium-ion et contrôlant les circuits électriques pour effectuer la lithiation lors d'une diminution spécifiée détectée de l'ÉdS.

13. Système selon la revendication 12, dans lequel le SSB est en outre configuré pour détecter, sur la base de l'ÉdS surveillé, laquelle des électrodes doit être lithiée et pour contrôler les circuits électriques en conséquence.

14. Système selon les revendications 12 ou 13, dans lequel le SSB est en outre configuré pour distinguer, sur la base de l'ÉdS surveillé, si des anodes ou des cathodes doivent être lithiées pour au moins une des électrodes, et pour contrôler les circuits électriques en conséquence.

15. Système selon l'une quelconque des revendications 12 à 14, dans lequel le SSB est en outre configuré pour mesurer une tension entre la source de lithium et les anodes après une charge et/ou les cathodes après une décharge, et pour contrôler les circuits électriques en conséquence.
